# EUROPÄISCHE PATENTSCHRIFT

(11) **EP 4 139 698 B1**
(45) Veröffentlichungstag und Bekanntmachung des Hinweises auf die Patenterteilung: **18.12.2024**
(21) Anmeldenummer: 20722284.5
(22) Anmeldetag: 24.04.2020
(51) Int. Cl.: G01R 31/3835, G01R 31/385, G01R 31/389, G01R 31/392

(54) **VERFAHREN UND VORRICHTUNG ZUR PRÜFUNG EINES BATTERIEZUSTANDS BEI WENIGSTENS EINER BATTERIE**
METHOD AND DEVICE FOR TESTING A BATTERY STATE IN AT LEAST ONE BATTERY
PROCÉDÉ ET DISPOSITIF DE TEST D'UN ÉTAT DE BATTERIE D'AU MOINS UNE BATTERIE

(43) Veröffentlichungstag der Anmeldung: 01.03.2023
(73) Patentinhaber: CMWTEC Technologie GmbH, 65594 Runkel-Ennerich (DE)
(72) Erfinder: ALI-OGALLI, Mohammed Radhi, 65549 Limburg a. d. Lahn (DE); JACOBS, Michael, 35759 Driedorf (DE); ZINGER, Erik, 16515 Oranienburg (DE)
(74) Vertreter: Weckenbrock, Matthias
(86) Internationale Anmeldenummer: PCT/EP2020/061445
(87) Internationale Veröffentlichungsnummer: WO 2021/213669

(56) Entgegenhaltungen:
- EP-A1- 1 115 171
- EP-A1- 2 778 697
- WO-A2-2016/198959
- CN-A- 107 782 974
- US-A- 5 193 067
- US-A1- 2017 350 946
- US-B1- 9 157 968
- DEL VALLE JORGE ALONSO ET AL: "Analysis of Advanced Lithium-Ion Batteries for Battery Energy Storage Systems", 2018 IEEE INTERNATIONAL CONFERENCE ON ENVIRONMENT AND ELECTRICAL ENGINEERING AND 2018 IEEE INDUSTRIAL AND COMMERCIAL POWER SYSTEMS EUROPE (EEEIC / I&CPS EUROPE), IEEE, 12 June 2018 (2018-06-12), pages 1 - 6, XP033422443, DOI: 10.1109/EEEIC.2018.8493934

## Beschreibung

Die Erfindung betrifft ein Verfahren zur Prüfung eines Batteriezustands bei wenigstens einer Batterie nach Anspruch 1. Ein zweiter Aspekt der Erfindung betrifft eine Vorrichtung zur Prüfung eines Batteriezustands bei wenigstens einer Batterie nach Anspruch 13.

Batterien, beispielsweise für Kraftfahrzeuge, können bereits bei der Produktion sogenannte Batteriefehler aufweisen. Ziel ist es daher, diese Batteriefehler möglichst frühzeitig zu erkennen und fehlerhafte Batterien auszusortieren.

Die häufigsten Batteriefehler können zum einen den sogenannten Separator der Batterie betreffen.

Ein Batterieseparator hat die Aufgabe, Kathode und Anode in Batterien beziehungsweise negative und positive Elektrode in Akkumulatoren räumlich zu trennen. Der Separator muss eine Barriere sein, die die beiden Elektroden elektrisch voneinander isoliert, um interne Kurzschlüsse zu vermeiden. Gleichzeitig muss der Separator jedoch durchlässig für Ionen sein, damit die elektrochemischen Reaktionen in der Zelle ablaufen können. Ein Batterieseparator muss dünn sein, damit der Innenwiderstand möglichst gering ist und eine hohe Packungsdichte erzielt werden kann, so dass gute Leistungsdaten und hohe Kapazitäten möglich sind. Ferner dienen Separatoren dazu, den Elektrolyten aufzusaugen und bei geschlossenen Zellen den Gasaustausch zu gewährleisten.

Ein typischer Batteriefehler ist ein beschädigter Separator, im englischen auch als "damaged separator" bezeichnet.

Bei dem als "short separator" bezeichneten Batteriefehler liegt ein verkürzter Separator vor, so dass nicht die geometrisch vollständige Kontaktfläche zwischen Separator und der Plattenfläche der Elektrode abgedeckt ist.

Ferner kann es zu unerwünschten sogenannten Massenklumpen, englisch "mass lump", kommen, welche sich als Verschmutzung auf der Kathode oder Anode der Batterie bei der Herstellung ansammeln und so die Eigenschaften der Batterie deutlich verschlechtern.

Auch kann eine gebogene Elektroden-Platte, im englischen auch "bent plate" genannt, vorliegen, was zu einem Kurzschluss der Batterie führen könnte.

Ein weiterer häufiger Batteriefehler ist die umgekehrte Polarität ("reverse polarity"). Dies trifft dann zu, wenn bei der Herstellung der Batterie versehentlich die Elektroden vertauscht eingesetzt wurden.

Nicht nur bei der Produktion der Batterien können Batteriefehler auftreten, sondern auch während des Betriebes bzw. des Einsatzes der Batterien. Denn Batterien unterliegen im Laufe ihrer Lebensdauer einer Vielzahl an Lade-und Entladevorgängen. Hinzu kommen Belastungen durch Temperaturschwankungen. Diese Faktoren tragen dazu bei, dass verschiedene Arten von unerwünschten Batteriefehlern bzw. Batteriedefekten auftreten können.

Aus der DE 10 2015 005 132 A1 ist ein Verfahren zur Überprüfung einer Batterie für ein Kraftfahrzeug bekannt, bei welchem eine Zellspannung von Einzelzellen der Batterie ermittelt und die ermittelte Zellspannung automatisch mit einem Prüfparameter verglichen wird. Hierdurch können in Fahrzeugwerkstätten ausgetauschte Batterien vor deren Weitergabe hinsichtlich ihrer Sicherheit bewertet werden.

Die EP 1 037 063 A1 beschreibt eine Erkennungsvorrichtung zur Fehlererkennung bei einem Batteriesatz, welche ein Voltmeter und ein Amperemeter umfasst. Die Fehlererkennung erfolgt anhand der Bestimmung eines Innenwiderstands des Batteriesatzes.

Aus der DE 10 2013 013 471 A1 ist ein Verfahren zur Bestimmung der Zuleitungsimpedanz im mehrzelligen Batteriepacks zur Leitungsfehlererkennung bekannt. Hierbei wird auf das Vorliegen eines Leitungsfehlers geschlossen, wenn jeweilige Spannungsdifferenzen an verschiedenen Zellen innerhalb des Batteriepacks verschiedene Vorzeichen aufweisen.

Dieser Innenwiderstand bzw. die Impedanz einer Batterie ist stark frequenzabhängig. Er sinkt mit steigender Frequenz und kann Blindanteile aufweisen. Deshalb spricht man auch von komplexer Impedanz und stellt sie entweder nach Betrag und Phase dar, beispielsweise als Bode-Diagramm, oder nach Realteil und Imaginärteil, dann als Ortskurve.

Die umfangreichsten Einblicke in das Batterieverhalten erlaubt die sogenannte spektrale Impedanzmessung, welche auch elektrisches Impedanz-Spektrum, kurz EIS, genannt wird. Hierbei kann der - komplexe - Innenwiderstand bei mehreren Frequenzen, beispielsweise bei 0,1 Hz bis 1 kHz gemessen werden, was den Messvorgang auf einige Minuten verlängern kann. Aus dem Frequenzgang bzw. der Ortskurve kann das elektrochemische Verhalten abgelesen werden. Weicht die Ortskurve beispielsweise stark vom typischen Verlauf ab, kann auf Beschädigungen geschlossen werden.

Beispielsweise auch aus der DE 10 2004 063 431 A1 geht die Bestimmung des Innenwiderstands einer Batterie aus einem Strom-Zeit-Integral des Stromverlaufs und aus einem Spannungs-Zeit-Integral einer linear abfallenden Spannungsantwort hervor.

Wie erwähnt, wird diese Impedanzspektroskopie (EIS) in bekannter Weise in elektrochemischen Systemen, d.h. in Batterien, beispielsweise in Blei-Säure-Batterien verwendet, um die elektrochemischen Eigenschaften des Systems zu analysieren, zu charakterisieren und zu untersuchen. Bei dieser Messtechnik wird ein Spektrum eines sinusförmigen Signals mit einem Frequenzbereich, beispielsweise zwischen µHz und MHz an den Energiespeicher, beispielsweise die Batterie, angelegt und der Frequenzgang analysiert.

Die Impedanz spiegelt Amplitudenverstärkung und Phasenverschiebung wider. Sie wird bei verschiedenen Frequenzen, ausgehend von mehreren Kilohertz bis hinab in den Millihertz-Bereich ermittelt, um so das Impedanzspektrum der Batterie zu erfassen. Änderungen des Batterieverhaltens infolge der Temperatur, des Ladezustands (State of Charge, SOC) oder der Strombelastung spiegeln sich in entsprechend veränderten Impedanzkurven wider.

Auch aus der EP 1 892 536 A1 ist eine Überwachung des Alterungszustandes (SoH), des Ladezustandes (SoC) und des Grads der Funktionserfüllung (SoF) bekannt, wozu eine Impedanzspektroskopie durchgeführt wird. Bei der Impedanzspektroskopie wird die Batterie nicht belastet, so dass das Verfahren lediglich für die Bestimmung des Betriebszustandes, d.h. Ladungszustand und Alterungszustand geeignet ist. Beide Größen werden durch die aktuell entnehmbare Kapazität bzw. die maximal im Volladezustand entnehmbare Kapazität bei einem geringen Laststrom und bei definierter Temperatur berechnet.

Hiervon ausgehend schlägt die DE 10 2016 216 664 A1 ein Verfahren zur Feststellung der Funktionssicherheit einer Niedervoltbatterie eines zumindest teilweise elektrisch angetriebenen Fahrzeugs vor, die mit einem Prüfpuls belastet wird, wobei sich die Funktionssicherheit der Batterie aus einer Korrelation des sich während des Prüfpulses ergebenden Spannungsverlaufes an der Batterie mit einer vorgegebenen Funktionsanforderung, wobei die Funktionssicherheit gegeben ist, wenn der Spannungsverlauf der Batterie während des Prüfpulses mehreren unabhängigen Prüfkriterien genügt.

Die US 2017/350946 A1 und die EP 2 778 697 A1 beziehen sich auf eine Technik zum Überwachen eines Zustands einer Speicherbatterie, die effektiv auf ein Speicherbatterie-Zustandsüberwachungssystem angewendet werden soll, sowie auf ein Speicherbatterie-Zustandsüberwachungsverfahren und auf ein Speicherbatterie-Zustandsüberwachungsprogramm, in dem ein Zustand einer Speicherbatterie, die ständig mit einer Vorrichtung zur Verwendung bei der Notstromversorgung verbunden ist.

Die EP 1 115 171 A1 betrifft ein Verfahren zum Beurteilen des Zustands einer Sekundärbatterie, wie beispielsweise einer Nickel-Wasserstoff-Batterie und einer Lithium-Sekundärbatterie, insbesondere ein Verfahren zum Beurteilen der anfänglichen Aktivität und Verschlechterung derselben. Ferner ist ein Verfahren zum Regenerieren einer Sekundärbatterie und insbesondere ein Verfahren zum Regenerieren einer Nickel-Wasserstoff-Batterie beschrieben.

In dem Beitrag "Analysis of Advanced Lithium -Ion Batteries for Battery Energy Storage Systems" zur International Conference in Environment and Electrical Engineering (IEEE) 2018 werden verschiedene Prüfverfahren für Batteriezellen beschrieben.

Die WO 2016/198 959 A2 bezieht sich auf eine Vorrichtung zum Bestimmen des Funktionszustands einer Batterie.

Die US 5 193 067 A bezieht sich auf eine Batteriezustandserfassungsvorrichtung zum genauen Bestimmen eines Ladezustands, nämlich einer Kapazität einer Fahrzeugbatterie.

Die US 9 157 968 B1 betrifft wiederaufladbare Batterien und insbesondere ein verbessertes System und Verfahren zum Charakterisieren des Zustands einer wiederaufladbaren Batterie.

Die CN 107 782 974 A betrifft das Gebiet der Erfassung des Innenwiderstands einer Batterie, insbesondere ein Verfahren und eine Vorrichtung zur Online-Erfassung des Innenwiderstands einer Blei-Säure-Batterie.

Bei den bekannten Verfahren findet daher zum eindeutigen Identifizieren mehrerer Fehler zunächst ein einziger Test zur Bestimmung eines Fehlers der Batterie statt.

Für die genaue Identifizierung des oder der Batteriefehler wird bei bekannten Verfahren zunächst eine einzelne Messung an der Batterie durchgeführt. Anschließend wird die Batterie für mehrere Wochen in Quarantäne gebracht, das heißt beispielsweise in einem Lagerhaus eingelagert. Danach wird die Batterie ein weiteres Mal getestet, um möglicherweise einen weiteren Fehler feststellen zu können.

Dies ist nachteilig, da zahlreiche Batterien für mehrere Wochen einzulagern sind, was enorme Lagerkosten verursacht.

Mit diesen bekannten Prüfverfahren ist es ebenfalls lediglich möglich, bis zu drei der fünf häufigsten Fehler zu erkennen. Zwei der häufigsten Fehler können erst nach Auslieferung der Batterie und nach einer Betriebsdauer von 1 bis 2 Jahren festgestellt werden.

Diese Fehlererkennung hängt vom Grad der Einwirkung der Fehler an der vorgegebenen Testzeit ab. Ein üblicher Test bei der Herstellung der Batterien ist der Hochstromtest (HRD). Mittels dieses Tests können jedoch nur die Fehler identifiziert werden, die unmittelbar unterschiedliche elektrische Messungen aufweisen, beispielsweise eine deutlich mangelhafte Zelle oder eine abgerissene Zellbrücke.

Um jedoch bereits bei neu hergestellten Batterien bei einer Qualitätskontrolle feststellen zu können, ob die Batterie einen Fehler aufweist, welcher zu hohem Spannungs- bzw. Kapazitätsverlust führt, sind die Batterien in einer "Quarantäne" zu lagern, um dann nach einigen Wochen eine Prüfung auf Spannungs- bzw. Kapazitätsverlust durchführen zu können.

Auch kann mit den bekannten Testverfahren ein Teil der Batteriefehler erst nach langfristigen mechanischen oder thermischen Beanspruchung der Batterie oder durch Alterung wirksam werden, beispielsweise könnte eine gebogene Platte erst nach gewissen Vibrationen oder Alterung (Sulfatierung) zu einem Kurzschluss führen.

Nachteilig an dem bekannten Stand der Technik ist ferner, dass die Funktionserfüllung von Batterien nur unzureichend festgestellt werden kann.

Ausgehend von den zuvor beschriebenen Nachteilen liegt der Erfindung die Aufgabe zugrunde, ein Verfahren sowie eine Vorrichtung der eingangs genannten Art zu schaffen, welche mit einfachen Mitteln eine besonders frühzeitige und genaue Erkennung eines Batteriefehlers ermöglichen.

Diese Aufgabe wird gelöst mit einem Verfahren zur Prüfung eines Batteriezustands bei wenigstens einer Batterie nach Anspruch 1. Diese Aufgabe wird ebenfalls gelöst mit einer Vorrichtung zur Prüfung eines Batteriezustands bei wenigstens einer Batterie nach Anspruch 13.

### Darstellung der Erfindung

Die Erfindung betrifft ein Verfahren zur Prüfung eines Batteriezustands bei wenigstens einer Batterie, insbesondere zur Bestimmung eines Batteriefehlers mit zumindest folgenden Schritten:
Durchführung eines ersten Impedanztests mit Bestimmung des Innenwiderstands der Batterie, wobei die Batterie mit einem elektrischen Stromverlauf belastet und eine resultierende Spannungsantwort der Batterie gemessen wird,
Erfassung und Speicherung der Messergebnisse dieses ersten Impedanztests,
Durchführung eines Belastungs-Hochstromtest der Batterie mit einem Prüfpuls bzw. Entladepuls, vorzugsweise für wenige Sekunden,
Durchführung eines zweiten Impedanztests, vorzugsweise nach einer Pause von 1 bis 10, insbesondere 2 Sekunden,
Erfassung und Speicherung der Messergebnisse dieses zweiten Impedanztests,
Auswertung des Tests, indem die Messerergebnisse des ersten, des zweiten Impedanztests und/oder des Belastungs-Hochstromtest derart miteinander in Bezug gebracht werden, insbesondere miteinander verrechnet werden, dass daraus der Batteriezustand abzuleiten ist, insbesondere ob eine fehlerhafte Batterie vorliegt.

Mit anderen Worten wird zunächst ein Impedanztest der Batterie durchgeführt. Ein derartiger Batterietest kann einige wenige Sekunden dauern. Anschließend findet ein Belastungs-Hochstromtest statt und dann noch einmal ein Impedanztest als Vergleichsmessung zum ersten Impedanztest.

Die Messergebnisse des ersten Impedanztests werden mit denen des zweiten Impedanztests in Verbindung gebracht, beispielsweise miteinander verrechnet. Aus diesem Ergebnis und mit dem Hochstromtest lassen sich dann die mangelhaften Batterien herausfiltern, welche dann auf einfache Weise aussortiert werden können.

Wie erwähnt, charakterisiert der Innenwiderstand die Fähigkeit einer Batterie, eine bestimmte Energie zu verarbeiten, bevor die Spannung unter einen vordefinierten Grenzwert, z.B. die Abschaltspannung, absinkt.

Der gesamte Innenwiderstand der Batterie besteht aus dem ohmschen Widerstand und dem Ladungsübertragungswiderstand (engl. Charge Transfer R_{CT}), welcher auch Polarisationswiderstand genannt wird. Der ohmsche Widerstand stellt den Elektrodenwiderstand, Elektrolytwiderstand, Separatorwiderstand und Kontaktwiderstand jedes Teils dar und kann durch die elektrochemische Impedanzanalyse, den sogenannten ACR, bei einer einzigen Frequenz bewertet werden.

Um den Ladungsübertragungswiderstand der Batterie zu bestimmen, kann die Batterie mit zwei schnellen Impulsen entladen und der Spannungsabfall entsprechend dem entladenen Strom bewertet werden. Dieser Prozess verwendet nur den Gleichstrom der Batterie und wird auch als DCR-Test bezeichnet. Auf diese Weise kann man den gesamten Innenwiderstand der Batterie erhalten und daraus den Ladungsübertragungswiderstand bestimmen. Diese beiden Testverfahren, d.h. ACR und DCR bieten die maximale Untersuchungsmöglichkeit der Batterieleistung während einer sehr begrenzten Testzeit, was insbesondere auf einer Produktionslinie vorteilhaft ist, da dadurch nicht die Taktzeiten verlängert werden.

Bei dem Belastungs-Hochstromtest wird die Batterie mittels Prüfpuls bzw. Entladepuls mit einem relativ hohen Strom entladen, die Spannung wird während und nach dem Test beobachtet. Durch diese Belastung der Batterie werden die elektrochemischen Eigenschaften der Batterie geändert. Diese Änderung lässt sich durch Impedanzanalyse verhältnismäßig zu den fehlerhaften und fehlerfreien Batterien widerspiegeln.

Der Belastungs-Hochstromtest, im englischer Sprache auch High Rate Discharge, HRD, genannt, erfolgt anhand des Entladens der Batterie mit hohem Strom. Beispielsweise kann die Batterie mit mehr als der 10-fachen sogenannten C-Rate entladen werden.

Die C-Rate beschreibt den Lade- oder Entladestrom einer Batterie, insbesondere eines Akkus, bezogen auf seine Kapazität. Mit ihm können beispielsweise die maximal zulässigen Lade- und Entladeströme, abhängig von der Nennkapazität angegeben werden. Der Faktor wird auch genutzt um im umgekehrten Fall die Akku-Kapazität in Abhängigkeit von der Entladestromstärke zu spezifizieren. Der C-Faktor ist definiert als der Quotient aus diesem Strom und der Kapazität. Beispielsweise bei einer Kapazität von 70 Ah würde der 10-fache Entladestrom einer Stromstärke von 700A entsprechen. Die Batterie kann mit konstantem Strom, konstanter Spannung oder konstante Leistung entladen werden.

Beim Belastungs-Hochstromtest können die Ruhespannung (open circuit voltage, OCV) und die Lastspannung am Ende der Entladepuls (constant current voltage, CCV) verwendet werden, um über den Batteriezustand Aussage zu treffen.

Bei den getesteten Batterien kann es sich beispielsweise um sogenannte geflutete Blei-Säure-Batterien oder auch um verschlossene Batterien sowie um Lithium-Ion Batterien handeln

Erfindungsgemäß wird die Differenz zwischen dem Messergebnis des ersten und des zweiten Impedanztest gebildet, um daraus abzuleiten, ob dieser Differenzwert außerhalb eines vorgegebenen Intervalls liegt. Anhand der Differenzwerte wird ermittelt, ob eine unzulässige Verschlechterung des Batteriezustands vorliegt oder bevorsteht. Beispielsweise können die fehlerhaften Batterien gegenüber fehlerfreien Batterien eine Abweichung von 10% bis 30%, insbesondere von 20% aufweisen.

Gemäß einer vorteilhaften Weiterentwicklung der Erfindung wird der Belastungshochstromtest für eine Dauer von etwa 1 bis 10 Sekunden, insbesondere für 3 Sekunden durchgeführt. Dieser Zeitraum ist vorteilhaft, um die Qualität der Batterie sicherzustellen und mehr fehlerhafte Batterien herausfiltern zu können. Eine deutlich längere Testzeit, wie aus dem Stand der Technik bekannt, führt zur Verlangsamung der Produktion und einem erheblichen Energieverlust beim Herstellungsverfahren.

In einer weiteren vorteilhaften Variante der Erfindung werden die Messwerte der einzelnen Messungen frei konfigurierbar miteinander in Beziehung gebracht. Aufgrund der Speicherung der Messwerte der einzelnen Verfahrensschritte können diese für unterschiedliche Testprofile vergleichen und für weitere Auswertungen, sowie statistische Berechnungen herangezogen werden. Der Benutzer kann je nach Batterietyp und -kapazität bestimmte Testparameter wie Strom, Spannung, Testdauer, Pausezeit und Auswertungslimit einstellen. Die aktuellen Messwerte können dann mit vorherigen Messdaten statistisch verglichen werden. Hierzu können der Mittelwert und die Standardabweichung von den Ergebnissen ermittelt werden und beispielsweise für die Definition einer Auswertungsgrenze eingesetzt werden.

In einer vorteilhaften Ausgestaltung der Erfindung ist vorgesehen, dass mehrere, insbesondere zwischen 3 und 5 einzelne Testverfahren an einer Batterie durchgeführt werden und die Ergebnisse der einzelnen Messergebnisse miteinander in Bezug gebracht werden, um dann eine fehlerhafte Batterie zu identifizieren. Beispielsweise können die Testverfahren Entladung der Batterie bei konstantem Strom (constant current discharge), Entladung bei konstanter Spannung (constant voltage discharge), Entladung bei konstanter Leistung (constant power discharge), Gleichspannungs-Innenwiderstandsmessung (DC internal resistance) und Messung des Wechselstromwiderstands (AC Impedanz) in einer Testsequenz hintereinander ausgeführt und die entsprechenden Messergebnisse miteinander kombiniert werden.

Gemäß einer Weiterbildung der Erfindung wird der erste und/oder der zweite Impedanztest der Batterie bei einer festen Frequenz, insbesondere bei einer Frequenz von etwa 1 kHz durchgeführt. Diese Messung wird auch Einfrequenzmessung genannt. Die gewählte Frequenz hängt vom Batterietyp und der Testzeit ab. Beispielsweise bei Bleibatterien weisen die Impedanz-Werte einen stabilen realen Anteil und einen geringen imaginären Anteil ab etwa 100 Hz bis ca. 1 KHz auf. Die Einfrequenzmessung hat gegenüber einer Messung bei einem Frequenzspektrum den Vorteil, die Testzeit zu verkürzen und dennoch eine aussagekräftige Anzeige der Batterie zu erhalten. Die Einfrequenzmethode ist auch als ACR-Test bekannt, der den ohmschen Innenwiderstand der Batterie, auch Elektrolytwiderstand genannt, darstellt. Vorliegend kann das Verfahren in wenigen Millisekunden durchgeführt werden. Dadurch ist ein Einsatz in sogenannten End-of-Line-Testmaschinen in Produktionslinien bei der Herstellung der Batterien problemlos möglich.

In einer Weiterbildung der Erfindung ist vorgesehen, dass der erste und/oder der zweite Impedanztest der Batterie bei mehreren Frequenzen, insbesondere bei etwa 0,5 Hz, 50 Hz und 500 Hz durchgeführt wird. Das bietet die Möglichkeit, den optimalen Frequenzbereich zu erhalten, bei dem die Messergebnisse möglichst aussagekräftiger sind.

Eine weitere vorteilhafte Ausgestaltung der Erfindung sieht vor, dass der erste und/oder der zweite Impedanztest der Batterie bei einem Frequenzspektrum, insbesondere bei einem Frequenzspektrum zwischen 0,1 Hz und 1 MHz durchgeführt wird.

Bei der Berechnung der Impedanz können Fourierreihen verwendet werden. Dadurch kann der Parameter des Ersatzschaltkreises der Batterie identifiziert werden, indem ein bestimmter Frequenzbereich des Spektrums verwendet wird, beispielsweise 0,1 Hz bis 7,5 kHz für Blei-Säure-Batterien. Beispielsweise können mit einem sogenannten Nyquist-Diagramm die Impedanz-Messwerte durch Fourier-Transform zur komplexen Nummer als reale und imaginäre Zahlen dargestellt werden. Hierzu muss die Batterie mit einem Frequenzspektrum von ca. 0,1 Hz bis 7,5 KHz angeregt und die Signalantwort gemessen werden. Anhand dieses Diagrammes können die Parameter des Ersatzschaltbildes bestimmt bzw. ausgelesen werden. Diese Parametrisierung trägt dazu bei, die elektrochemischen Eigenschaften der Batterien besser untersuchen zu können. Auf diese Weise lassen sich auch die Fehler in der Batterie durch Impedanzanalyse widerspiegeln.

Gemäß einer weiteren Variante der Erfindung wird der Entladepuls des Hochstrom-Belastungstests für eine Pulsdauer von 1 bis 10 Sekunden, vorzugsweise von 2 bis 4 Sekunden, insbesondere 3 Sekunden aufrechterhalten. Das erhöht den Produktionstakt und reduziert den Energieverlust.

Es kann in Bereich der Blei-Säure-Batterien vorgesehen sein, dass der Prüfpuls bzw. Entladepuls des Hochstrom-Belastungstests weist eine Stromstärke von etwa 500 bis 3000 Ampere auf. Die gewählte Stromstärke hängt von der Batteriekapazität ab und kann je nach Batteriehersteller und Belastungsdauer bestimmt werden. In Prinzip gilt hier die C-Rate der Batterie, beispielsweise kann die Batterie auf einen Wert zwischen der 1 bis 20-fachen C-Rate belastet werden. Wie erwähnt, beschreibt die C-Rate den Lade- oder Entladestrom einer Batterie, insbesondere eines Akkus, bezogen auf seine Kapazität. Mit ihm können beispielsweise die maximal zulässigen Lade- und Entladeströme, abhängig von der Nennkapazität angegeben werden. Beispielsweise würde die 15-fache C-Rate einer 100 AH Batterie einer Stromstärke von 1500 A entsprechen.

In vorteilhafter Weise kann es vorgesehen sein, dass die Stromstärke des Prüfpulses bzw. Entladepulses des Hochstrom-Belastungstests stufenweise ansteigt. Damit kann der optimale Belastungsgrad für die jeweilige Batterie-Bauform bestimmt werden, bei dem die Fehler bestmöglich identifiziert werden können. Ferner wird auch eine unnötige Belastung der Batterie vermieden.

Es kann auch vorgesehen sein, dass sogenannte Entladekurven, d.h. die Spannung und der Strom bei der Entladung der Batterie während der Tests gebildet werden, um das Verhalten der Batterie unter Last genau zu untersuchen. Die Entladung der Batterie kann bei konstantem Strom oder bei konstanter Spannung oder bei konstanter Leistung gemessen und die Messergebnisse abgespeichert werden.

Gemäß einem unabhängigen Gedanken der Erfindung ist eine Vorrichtung zur Prüfung eines Batteriezustands bei wenigstens einer Batterie vorgesehen, ausgebildet zur Durchführung des oben beschriebenen Verfahrens, welche eine Impedanz-Messvorrichtung zur Durchführung wenigstens eines ersten und eines zweiten Impedanztests mit Bestimmung des Innenwiderstands der Batterie aufweist, wobei eine Hochstrom-Vorrichtung zur Durchführung eines Belastungs-Hochstromtest der Batterie mit einem Prüfpuls bzw. Entladepuls vorgesehen ist und wobei die Vorrichtung eine Auswerteeinheit zur Auswertung der Tests aufweist. Erfindungsgemäß ist vorgesehen, dass die Auswerteeinheit zur Erfassung und Speicherung der Messergebnisse des ersten und des zweiten Impedanztests ausgebildet ist, insbesondere, dass mittels der Auswerteeinheit die Messerergebnisse des ersten und des zweiten Impedanztests und/oder des Belastungs-Hochstromtests derart miteinander in Bezug gebracht werden, insbesondere miteinander verrechnet werden, dass daraus der Batteriezustand abzuleiten ist, insbesondere ob eine fehlerhafte Batterie vorliegt.

Weitere Ziele, Vorteile, Merkmale und Anwendungsmöglichkeiten der vorliegenden Erfindung ergeben sich aus der nachfolgenden Beschreibung eines Ausführungsbeispiels anhand der Zeichnung. Der Gegenstand der vorliegenden Erfindung wird in den Ansprüchen definiert.

Dabei zeigen zum Teil schematisch:
- Figur 1: den Ablauf eines Verfahrens zur Bestimmung eines Batteriezustands,
- Figur 2: eine Vorrichtung zur Bestimmung des Batteriezustands und
- Figur 3: ein beispielhaftes Diagramm mit Messergebnissen.

Gleiche oder gleichwirkende Bauteile werden in den nachfolgend dargestellten Figuren der Zeichnung anhand einer Ausführungsform mit Bezugszeichen versehen, um die Lesbarkeit zu verbessern.

Batterien 10, beispielsweise für Kraftfahrzeuge, können bereits bei der Produktion sogenannte Batteriefehler aufweisen. Ziel ist es daher, diese Batteriefehler möglichst frühzeitig zu erkennen und fehlerhafte Batterien 17 auszusortieren.

Wie oben bereits ausgeführt, ist einer der typischen Batteriefehler ein beschädigter Separator, im englischen auch als "damaged separator" bezeichnet. Bei dem als "short separator" bezeichneten Batteriefehler liegt ein verkürzter Separator vor, so dass nicht die geometrisch vollständige Kontaktfläche zwischen Separator und der Plattenfläche der Elektrode abgedeckt ist.

Ferner kann es zu unerwünschten sogenannten Massenklumpen, englisch "mass lump", bzw. Materialansammlungen kommen, welche sich als Verschmutzung auf der Kathode oder Anode der Batterie bei der Herstellung ansammeln und so die Eigenschaften der Batterie deutlich verschlechtern.

Auch kann eine gebogene Elektroden-Platte, im englischen auch "bent plate" genannt, vorliegen, was zu einem Kurzschluss der Batterie führen könnte.

Ein weiterer häufiger Batteriefehler ist die umgekehrte Polarität ("reverse polarity"). Dies trifft dann zu, wenn bei der Herstellung der Batterie 10 versehentlich die Elektroden vertauscht eingesetzt wurden.

Um nun derartige Fehler bereits bei der Herstellung der Batterien 10 feststellen zu können, so dass defekte Batterien 17 direkt aussortiert werden können, schlägt die Erfindung ein Verfahren und Vorrichtung 11 zur Bestimmung des Batteriezustandes vor.

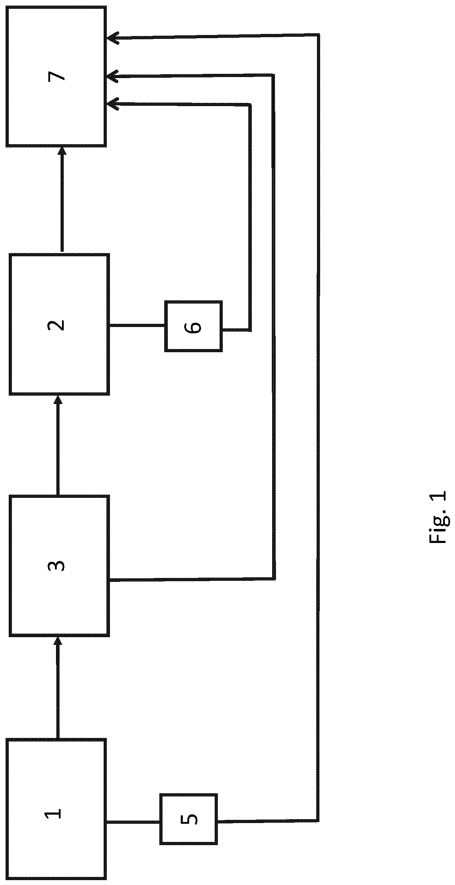

In Figur 1 ist ein Ablaufdiagramm eines Verfahrens zur Prüfung eines Batteriezustands bei wenigstens einer Batterie 10, insbesondere zur Bestimmung eines Batteriefehlers mit zumindest folgenden Schritten dargestellt:
Durchführung eines ersten Impedanztests 1 mit Bestimmung des Innenwiderstands der Batterie 10, wobei die Batterie 10 mit einem elektrischen Stromverlauf mit bestimmter Frequenz belastet und eine resultierende Spannungsantwort der Batterie 10 gemessen wird. Ein derartiger Batterietest kann einige wenige Sekunden dauern.

Dabei werden die Messergebnisse dieses ersten Impedanztests 1 erfasst und gespeichert 5. Diese Messwerte dienen als Referenzwerte für einen späteren, weiteren Impedanztest.

Anschließend wird ein Belastungs-Hochstromtest 3 der Batterie 10 mit einem Prüfpuls bzw. Entladepuls durchgeführt. Bei dem Belastungs-Hochstromtest 3 wird die Batterie 10 mittels Prüfpuls bzw. Entladepuls mit einem relativ hohen Strom entladen, die Spannung wird während und nach dem Test beobachtet. Durch diese Belastung der Batterie 10 werden ihre elektrochemischen Eigenschaften geändert. Diese Änderung lässt sich durch die Impedanzanalyse ausnutzen, da diese das Verhältnis von fehlerhafter zu fehlerfreien Batterien 10 widerspiegelt.

Beispielsweise kann die Batterie 10 mit mehr als der 10-fachen sogenannten C-Rate entladen werden, wobei die C-Rate den Lade- oder Entladestrom einer Batterie, insbesondere eines Akkus, bezogen auf seine Kapazität beschreibt. Beispielsweise bei einer Kapazität von 70 Ah würde der 10-fache Entladestrom einer Stromstärke von 700 A entsprechen. Die Batterie kann mit konstantem Strom, konstanter Spannung oder konstante Leistung entladen werden.

Beim Belastungs-Hochstromtest 3 können die Ruhespannung und die Lastspannung am Ende der Entladepuls verwendet werden, um über den Batteriezustand eine Aussage zu treffen.

Bei den getesteten Batterien 10 kann es sich beispielsweise um sogenannte geflutete Blei-Säure-Batterien oder auch um verschlossene Batterien sowie um Lithium-Ion Batterien handeln

Im Anschluss an diese Belastung der Batterie 10 wird ein zweiter Impedanztests 2 durchgeführt und auch dessen Messergebnisse werden erfasst und gespeichert 6. Dieser zweite Impedanztest 2 dient als Vergleichsmessung zum ersten Impedanztest 1.

Der erste 1 und/oder der zweite Impedanztest 2 der Batterie 10 kann bei einer festen Frequenz, insbesondere bei einer Frequenz von etwa 1 kHz durchgeführt werden. Diese Messung wird auch Einfrequenzmessung genannt. Die gewählte Frequenz hängt vom Batterietyp und der erlaubten Testzeit ab. Beispielsweise bei Bleibatterien weisen die Impedanz-Werte einen stabilen realen Anteil und einen geringen imaginären Anteil ab etwa 100 Hz bis ca. 1 KHz auf. Es ist aber auch denkbar, dass der erste 1 und/oder der zweite Impedanztest 2 der Batterie 10 bei mehreren Frequenzen, insbesondere bei etwa 0,5 Hz, 50 Hz und 500 Hz oder bei einem Frequenzspektrum, insbesondere bei einem Frequenzspektrum zwischen 0,1 Hz und 1 MHz durchgeführt wird.

Wesentlich bei der Erfindung ist die Auswertung 7 dieser Tests, d.h. der Impedanztests 1, 2 mit dazwischen ausgeführtem Belastungs-Hochstromtest 3. Die Messerergebnisse des ersten 1 und des zweiten Impedanztests 2 und/oder des Belastungs-Hochstromtest 3 werden in einer Auswerteeinheit 16 derart miteinander in Bezug gebracht, insbesondere miteinander verrechnet, dass daraus der Batteriezustand abzuleiten ist, insbesondere ob eine fehlerhafte Batterie 17 vorliegt.

Im vorliegenden Beispiel wird die Differenz 8 zwischen dem Messergebnis des ersten 1 und des zweiten Impedanztest 2 gebildet, um daraus abzuleiten, ob dieser Differenzwert 8 außerhalb eines vorgegebenen Intervalls 9 liegt. Anhand der Differenzwerte 8 wird ermittelt, ob eine unzulässige Verschlechterung des Batteriezustands vorliegt oder bevorsteht. Beispielsweise können die fehlerhaften Batterien 10 gegenüber fehlerfreien Batterien 10 eine Abweichung von 10% bis 30%, insbesondere von 20% aufweisen.

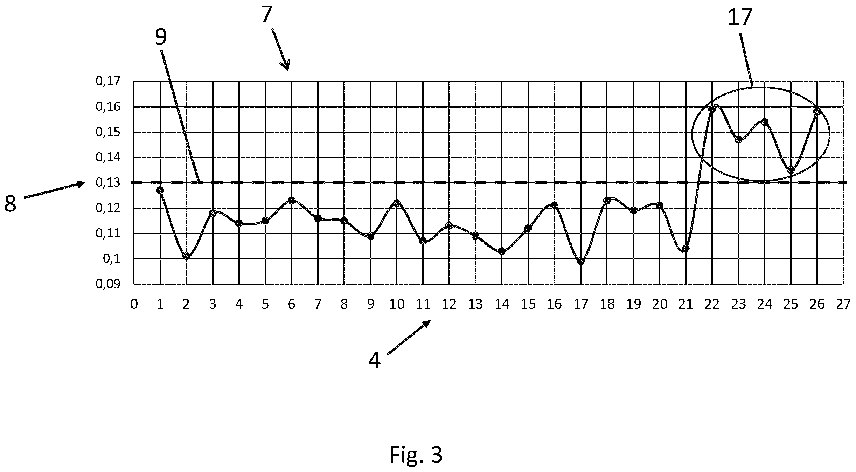

Das Ergebnis eines solchen Tests ist in Figur 3 dargestellt. Hier ist auf der x-Achse die Anzahl 4 der getesteten Batterien 10 aufgetragen, d.h. jeder getesteten Batterie 10 ist eine eindeutige Zahl mit einem entsprechenden Messpunkt zugeordnet. Vorliegend wurden demnach 26 Batterien 10 getestet.

Auf der y-Achse ist die Differenz 8 der Messwerte aus der ersten 1 und der zweiten Impedanzmessung 2 dargestellt. Im vorliegenden Ausführungsbeispiel liegt dieser Bereich zwischen 0,09 und 0,17.

Wie der Figur 3 weiter zu entnehmen ist, wurde für die Auswertung eine Grenze 9 für die Differenz 8 zwischen den Impedanzmessungen 1, 2 von 0,13 vorgegeben. Denkbar wäre auch ein bestimmtes Intervall 9 vorzugeben.

Die Batterien 10 mit den zugeordneten Nummer 1 bis 21 weisen sämtlich einen Wert für die Differenz 8 auf, welcher unterhalb der Grenze 9 liegt. Dagegen liegen die Differenzwerte 8 für die Batterien 10 mit den Nummern 22 bis 26 deutlich oberhalb dieser Grenze 9. Bei diesen Batterien 10 handelt es sich um defekte Batterien 17, also solche mit einem Batteriefehler.

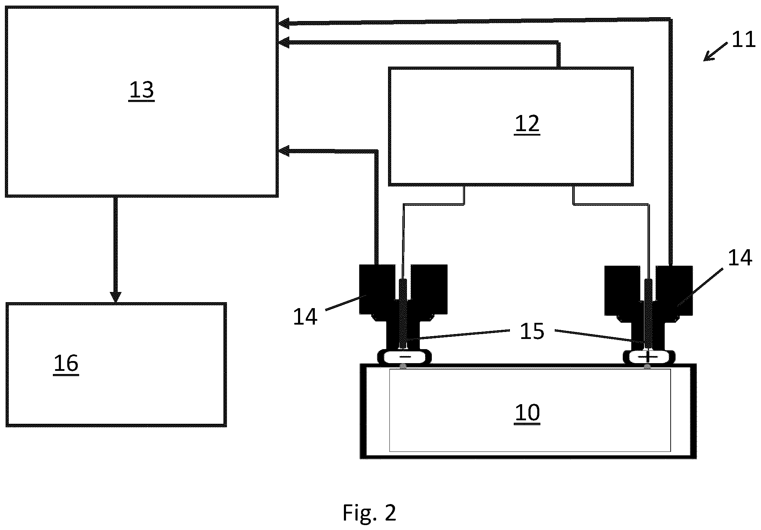

Figur 2 zeigt eine Vorrichtung 11 zur Prüfung eines Batteriezustands bei wenigstens einer Batterie 10, insbesondere zur Durchführung des oben beschrieben Verfahrens, welche eine Impedanz-Messvorrichtung 12 zur Durchführung wenigstens eines ersten 1 und eines zweiten Impedanztests 2 mit Bestimmung des Innenwiderstands der Batterie 10 aufweist.

Natürlich ist es im Sinne der Erfindung ebenfalls denkbar, mehr als zwei Impedanztests 1, 2 und mehrere Belastungs-Hochstromtests 3 durchzuführen und die einzelnen Messergebnisse entsprechend zu kombinieren.

Ferner ist eine Hochstrom-Vorrichtung 13 zur Durchführung und Messung eines Belastungs-Hochstromtest 3 der Batterie 10 mit einem Prüfpuls bzw. Entladepuls vorgesehen.

Mit Bezugszeichen 15 sind Messkontakte, insbesondere vierpolige Messkontakte für die Impedanzmessungen bezeichnet. Daran angeschlossen sind Stromklemmen 14, welche insbesondere als Zangenstrom, auch Stromzange ausgebildet sein können.

Ferner weist die Vorrichtung 11 eine Auswerteeinheit 16 zur Auswertung 7 der Tests auf. Die Auswerteeinheit 16 ist zur Erfassung und Speicherung der Messergebnisse 5 des ersten 1, des zweiten Impedanztests 2 und/oder des Hochstromtest 3 ausgebildet.

Bei der Auswerteeinheit 16 kann es sich um eine speicherprogrammierbare Steuerung (SPS) handeln, welche zur Steuerung oder Regelung der Vorrichtung 11 eingesetzt und auf digitaler Basis programmiert wird. Eine SPS hat im einfachsten Fall Eingänge, Ausgänge, ein Betriebssystem (Firmware) und eine Schnittstelle, über die das Anwenderprogramm geladen werden kann. Das Anwenderprogramm legt fest, wie die Ausgänge in Abhängigkeit von den Eingängen geschaltet werden sollen. Ferner ist die Auswerteeinheit 16 im vorliegenden Ausführungsbeispiel dafür ausgelegt, die Messwerte der Impedanztests zu analysieren und Messergebnisse auszugeben.

Im Sinne der Erfindung ist es auch denkbar, dass mehrere, insbesondere zwischen 3 und 5 einzelne Testverfahren an einer Batterie 10 durchgeführt werden und die Ergebnisse der einzelnen Messergebnisse miteinander in Bezug gebracht werden, um dann eine fehlerhafte Batterie 17 zu identifizieren. Beispielsweise können die Testverfahren Entladung der Batterie 10 bei konstantem Strom (constant current discharge), Entladung bei konstanter Spannung (constant voltage discharge), Entladung bei konstanter Leistung (constant power discharge), Gleichspannungs-Innenwiderstandsmessung (DC internal resistance) und Messung des Wechselstromwiderstands (AC Impedanz) in einer Testsequenz hintereinander ausgeführt und die entsprechenden Messergebnisse miteinander kombiniert werden.

### Bezugszeichenliste

- 1: erster Impedanztest
- 2: zweiter Impedanzest
- 3: Belastungs-Hochstromtest
- 4: Anzahl der getesteten Batterien
- 5: Erfassung und Speicherung der Messergebnisse
- 6: Erfassung und Speicherung der Messergebnisse
- 7: Auswertung der Tests
- 8: Differenz
- 9: vorgegebenes Intervall bzw. vorgegebene Grenze
- 10: Batterie
- 11: Vorrichtung
- 12: Impedanz-Messvorrichtung
- 13: Hochstrom-Vorrichtung
- 14: Stromklemmen
- 15: Messkontakte für die Impedanzmessung
- 16: Auswerteeinheit
- 17: defekte Batterie

## Patentansprüche

1. Verfahren zur Prüfung eines Batteriezustands bei wenigstens einer Batterie (10), insbesondere zur Bestimmung eines Batteriefehlers mit zumindest folgenden Schritten:
Durchführung eines ersten Impedanztests (1) mit Bestimmung des Innenwiderstands der Batterie (10), wobei die Batterie (10) mit einem elektrischen Stromverlauf mit bestimmter Frequenz angeregt und eine resultierende Spannungsantwort der Batterie (10) gemessen wird,
Erfassung und Speicherung der Messergebnisse (5) dieses ersten Impedanztests (1),
Durchführung eines Belastungs-Hochstromtest (3) der Batterie (10) mit einem Prüfpuls bzw. Entladepuls,
Durchführung eines zweiten Impedanztests (2),
Erfassung und Speicherung der Messergebnisse (6) dieses zweiten Impedanztests (2),
Auswertung (7) der Tests, indem die Messerergebnisse des ersten (1) und des zweiten Impedanztests (2) derart miteinander in Bezug gebracht werden, dass daraus der Batteriezustand abzuleiten ist, wobei die Differenz (8) zwischen dem Messergebnis des ersten (1) und des zweiten Impedanztests (2) gebildet wird, um daraus abzuleiten, ob dieser Differenzwert (8) außerhalb einer vorgegebenen Grenze (9) oder eines vorgegebenen Intervalls (9) liegt..

2. Verfahren nach Anspruch 1, **dadurch gekennzeichnet, dass** der Hochstrombelastungstest (3) für eine Dauer von etwa 1 bis 10 Sekunden, insbesondere für 3 Sekunden, durchgeführt wird.

3. Verfahren nach einem der vorherigen Ansprüche, **dadurch gekennzeichnet, dass** die Messwerte der einzelnen Messungen, insbesondere des ersten (1) und des zweiten Impedanztests (2) und/oder des Belastungs-Hochstromtests (3), frei konfigurierbar miteinander in Beziehung gebracht werden.

4. Verfahren nach einem der vorherigen Ansprüche, **dadurch gekennzeichnet, dass** mehrere, insbesondere zwischen 3 und 5 einzelne Testverfahren an einer Batterie (10) durchgeführt werden und die Ergebnisse der einzelnen Messergebnisse miteinander in Bezug gebracht werden, um dann eine fehlerhafte Batterie (10) zu identifizieren.

5. Verfahren nach Anspruch 4, **dadurch gekennzeichnet, dass** die Testverfahren an der Batterie (10) eine Entladung der Batterie (10) bei konstantem Strom, eine Entladung bei konstanter Spannung, eine Entladung bei konstanter Leistung, eine Gleichspannungs-Innenwiderstandsmessung oder eine Messung des Wechselstromwiderstands sind, wobei insbesondere einige oder alle dieser Testverfahren in einer Testsequenz hintereinander ausgeführt und die entsprechenden Messergebnisse miteinander kombiniert werden.

6. Verfahren nach einem der vorherigen Ansprüche, **dadurch gekennzeichnet, dass** der erste (1) und/oder der zweite Impedanztest (2) der Batterie (10) bei einer festen Frequenz, insbesondere bei einer Frequenz von etwa 1 kHz durchgeführt wird.

7. Verfahren nach einem der vorherigen Ansprüche, **dadurch gekennzeichnet, dass** der erste (1) und/oder der zweite Impedanztest (2) der Batterie (10) bei mehreren Frequenzen, insbesondere bei etwa 0,5 Hz, 50 Hz und 500 Hz durchgeführt wird.

8. Verfahren nach einem der vorherigen Ansprüche, **dadurch gekennzeichnet, dass** der erste (1) und/oder der zweite Impedanztest (2) der Batterie (10) bei einem Frequenzspektrum, insbesondere bei einem Frequenzspektrum zwischen 0,1 Hz und 1 MHz durchgeführt wird.

9. Verfahren nach einem der vorherigen Ansprüche, **dadurch gekennzeichnet, dass** der Prüfpuls des Hochstrom-Belastungstests (3) für eine Pulsdauer von 1 bis 10 Sekunden, vorzugsweise von 2 bis 4, insbesondere 3 Sekunden aufrechterhalten wird.

10. Verfahren nach einem der vorherigen Ansprüche, **dadurch gekennzeichnet, dass** der Prüfpuls des Hochstrom-Belastungstests (3) eine Stromstärke von etwa 500 bis 3000 Ampere aufweist oder dass der Prüfpuls des Hochstrom-Belastungstests (3) eine Stromstärke aufweist, welche etwa einem Wert zwischen der 1 bis 20 fachen C-Rate der Batterie (10) entspricht.

11. Verfahren nach einem der vorherigen Ansprüche, **dadurch gekennzeichnet, dass** die Stromstärke des Prüfpulses des Hochstrom-Belastungstests (3) stufenweise ansteigt.

12. Verfahren nach einem der vorherigen Ansprüche, **dadurch gekennzeichnet, dass** die Entladung der Batterie (10) bei konstantem Strom oder bei konstanter Spannung oder bei konstanter Leistung gemessen wird und die Messergebnisse abgespeichert werden.

13. Vorrichtung (11) zur Prüfung eines Batteriezustands bei wenigstens einer Batterie (10), ausgebildet zur Durchführung eines Verfahrens gemäß den vorherigen Ansprüchen, welche eine Impedanz-Messvorrichtung (12) zur Durchführung wenigstens eines ersten (1) und eines zweiten Impedanztests (2) mit Bestimmung des Innenwiderstands der Batterie (10) aufweist, wobei eine Hochstrom-Vorrichtung (13) zur Durchführung eines Belastungs-Hochstromtest (3) der Batterie (10) mit einem Prüfpuls bzw. Entladepuls vorgesehen ist und wobei die Vorrichtung (11) eine Auswerteeinheit (16) zur Auswertung (7) der Tests aufweist, wobei die Auswerteeinheit (16) zur Erfassung und Speicherung der Messergebnisse (5) des ersten (1), und des zweiten Impedanztests (2) ausgebildet ist, wobei mittels der Auswerteeinheit (16) die Messerergebnisse des ersten (1) und des zweiten Impedanztests (2) derart miteinander in Bezug gebracht werden, dass daraus der Batteriezustand abzuleiten ist.

## Claims

1. Method for testing a battery state of at least one battery (10), in particular for the identification of a battery defect, comprising at least the following steps:
Execution of a first impedance test (1) for determining the internal resistance of the battery (10), wherein the battery (10) is excited by means of an electric current characteristic at a specific frequency, and a resulting voltage response of the battery (10) is measured;
Capture and saving of the measurement results (5) of this first impedance test (1);
Execution of a high-rate discharge test (3) of the battery (10) by the application of a test pulse or discharge pulse;
Execution of a second impedance test (2);
Capture and saving of the measurement results (6) of this second impedance test (2);
Test evaluation (7), wherein the measurement results of the first (1) and the second impedance test (2) are considered in relation to one another, such that the battery state can be inferred therefrom; wherein a differential (8) is formed between the measurement result of the first (1) and the second impedance test (2), in order to infer herefrom whether this differential value (8) lies outside a stipulated limit (9) or a stipulated interval (9).

2. Method according to Claim 1, **characterized in that** the high-rate discharge test (3) is executed for a duration of approximately 1 to 10 seconds, in particular for 3 seconds.

3. Method according to one of the preceding claims, **characterized in that** measured values from individual measurements, in particular from the first (1) and second impedance test (2) and/or from the high-rate discharge test (3), are considered in relation to one another in a freely configurable manner.

4. Method according to one of the preceding claims, **characterized in that** multiple, in particular between 3 and 5 individual test procedures are executed on a battery (10), and that the outcomes of individual measurement results are considered in relation to one another, in order to identify a defective battery (10).

5. Method according to Claim 4, **characterized in that** test procedures executed on the battery (10) are constant current discharge of the battery (10), constant voltage discharge, constant power discharge, DC internal resistance measurement and AC impedance measurement wherein, in particular, a number or all of these test procedures are sequentially executed in a test sequence, and the corresponding measurement results are mutually combined.

6. Method according to one of the preceding claims, **characterized in that** the first (1) and/or the second impedance test (2) of the battery (10) is/are executed at a fixed frequency, in particular at a frequency of approximately 1 kHz.

7. Method according to one of the preceding claims, **characterized in that** the first (1) and/or the second impedance test (2) of the battery (10) is/are executed at multiple frequencies, in particular at approximately 0.5 Hz, 50 Hz and 500 Hz.

8. Method according to one of the preceding claims, **characterized in that** the first (1) and/or second impedance test (2) of the battery (10) is/are executed over a frequency spectrum, in particular over a frequency spectrum between 0.1 Hz and 1 MHz.

9. Method according to one of the preceding claims, **characterized in that** the test pulse in the high-rate discharge test (3) is sustained for a pulse duration of 1 to 10 seconds, preferably of 2 to 4 seconds, and in particular of 3 seconds.

10. Method according to one of the preceding claims, **characterized in that** the test pulse in the high-rate discharge test (3) assumes a current strength of approximately 500 to 3000 amperes, or **in that** the test pulse of the high-rate discharge test (3) assumes a current strength which corresponds to an approximate value of between 1 and 20 times the C-rate of the battery (10).

11. Method according to one of the preceding claims, **characterized in that** the current strength of the test pulse in the high-rate discharge test (3) is increased in a stepwise manner.

12. Method according to one of the preceding claims, **characterized in that** discharging of the battery (10) is measured at a constant current, or at a constant voltage, or at a constant power, and the measurement results are saved.

13. Device (11) for testing a battery state of at least one battery (10) which is designed to execute a method according to the preceding claims, and which comprises an impedance measuring device (12) for executing at least one first (1) and one second impedance test (2) for determining the internal resistance of the battery (10), wherein a high-current device (13) for executing a high-rate discharge test (3) of the battery (10) by means of a test pulse or discharge pulse is provided, and wherein the device (11) comprises an evaluation unit (16) for the evaluation (7) of tests, wherein the evaluation unit (16) is designed to capture and save measurement results (5) of the first (1) and second impedance tests (2), wherein, by means of the evaluation unit (16), measurement results of the first (1) and second impedance tests (2) are considered in relation to one another, such that the battery state can be inferred therefrom.

## Revendications

1. Procédé permettant de contrôler un état de batterie d'au moins une batterie (10), en particulier pour déterminer un défaut de batterie par au moins les étapes suivantes consistant à :
effectuer un premier test d'impédance (1) avec détermination de la résistance interne de la batterie (10), dans lequel la batterie (10) est excitée par un trajet de courant électrique à une fréquence déterminée, et une réponse en tension résultante de la batterie (10) est mesurée,
détecter et stocker les résultats de mesure (5) de ce premier test d'impédance (1),
effectuer un test de charge à courant fort (3) de la batterie (10) à l'aide d'une impulsion de contrôle ou d'une impulsion de décharge,
effectuer un deuxième test d'impédance (2),
détecter et stocker les résultats de mesure (6) de ce deuxième test d'impédance (2),
évaluer (7) les tests en mettant en relation les résultats de mesure du premier (1) et du deuxième test d'impédance (2) de telle sorte que l'état de batterie peut en être déduit, dans lequel la différence (8) entre le résultat de mesure du premier (1) et du deuxième test d'impédance (2) est formée afin d'en déduire si cette valeur de différence (8) est située à l'extérieur d'une limite prédéfinie (9) ou d'un intervalle prédéfini (9).

2. Procédé selon la revendication 1, **caractérisé en ce que** le test de charge à courant fort (3) est effectué pendant une durée d'environ 1 à 10 secondes, en particulier pendant 3 secondes.

3. Procédé selon l'une quelconque des revendications précédentes, **caractérisé en ce que** les valeurs mesurées des mesures individuelles, en particulier du premier (1) et du deuxième test d'impédance (2) et/ou du test de charge à courant fort (3) sont mis en relation les uns avec les autres de manière librement configurable.

4. Procédé selon l'une quelconque des revendications précédentes, **caractérisé en ce que** plusieurs, en particulier entre 3 et 5, procédés de test individuels sont effectués sur une batterie (10), et les résultats des résultats des résultats de mesure individuels sont mis en relation les uns avec les autres afin d'identifier ensuite une batterie (10) défectueuse.

5. Procédé selon la revendication 4, **caractérisé en ce que** les procédés de test sur la batterie (10) sont une décharge de la batterie (10) à courant constant, une décharge à tension constante, une décharge à puissance constante, une mesure de résistance interne à tension continue ou une mesure de la résistance de courant alternatif, dans lequel en particulier certains ou tous ces procédés de test sont effectués successivement dans une séquence de test, et les résultats de mesure correspondants sont combinés les uns avec les autres.

6. Procédé selon l'une quelconque des revendications précédentes, **caractérisé en ce que** le premier (1) et/ou le deuxième test d'impédance (2) de la batterie (10) sont effectués à une fréquence d'environ 1 kHz.

7. Procédé selon l'une quelconque des revendications précédentes, **caractérisé en ce que** le premier (1) et/ou le deuxième test d'impédance (2) de la batterie (10) sont effectués à plusieurs fréquences, en particulier à environ 0,5 Hz, 50 Hz et 500 Hz.

8. Procédé selon l'une quelconque des revendications précédentes, **caractérisé en ce que** le premier (1) et/ou le deuxième test d'impédance (2) de la batterie (10) sont effectués avec un spectre de fréquences, en particulier un spectre de fréquences compris entre 0,1 Hz et 1 MHz.

9. Procédé selon l'une quelconque des revendications précédentes, **caractérisé en ce que** l'impulsion de contrôle du test de charge à courant fort (3) est maintenue pendant une durée d'impulsion de 1 à 10 secondes, de préférence de 2 à 4, en particulier de 3 secondes.

10. Procédé selon l'une quelconque des revendications précédentes, **caractérisé en ce que** l'impulsion de contrôle du test de charge à courant fort (3) présente une intensité de courant d'environ 500 à 3000 ampères, ou **en ce que** l'impulsion de contrôle du test de charge à courant fort (3) présente une intensité de courant qui correspond environ à une valeur comprise entre 1 à 20 fois le taux C de la batterie (10).

11. Procédé selon l'une quelconque des revendications précédentes, **caractérisé en ce que** l'intensité de courant de l'impulsion de contrôle du test de charge à courant fort (3) augmente progressivement.

12. Procédé selon l'une quelconque des revendications précédentes, **caractérisé en ce que** la décharge de la batterie (10) est mesurée à courant constant ou à tension constante ou à puissance constante, et les résultats de mesure sont stockés.

13. Dispositif (11) permettant de contrôler un état de batterie d'au moins une batterie (10), réalisé pour exécuter un procédé selon l'une quelconque des revendications précédentes, qui présente un dispositif de mesure d'impédance (12) pour effectuer au moins un premier (1) et un deuxième test d'impédance (2) avec la détermination de la résistance interne de la batterie (10), dans lequel un dispositif à courant fort (13) est prévu pour effectuer un test de charge à courant fort (3) de la batterie (10) à l'aide d'une impulsion de contrôle ou d'une impulsion de décharge, et dans lequel le dispositif (11) présente une unité d'évaluation (16) pour évaluer (7) les tests, dans lequel l'unité d'évaluation (16) est réalisée pour détecter et stocker les résultats de mesure (5) du premier (1) et du deuxième test d'impédance (2), dans lequel au moyen de l'unité d'évaluation (16), les résultats de mesure du premier (1) et du deuxième test d'impédance (2) sont mis en relation les uns avec les autres de telle sorte que l'état de batterie peut en être déduit.
